**Europäisches Patentamt**

**European Patent Office**

**Office européen des brevets**

(19)

(11) Veröffentlichungsnummer: **0 167 213 B1**

(12) **EUROPÄISCHE PATENTSCHRIFT**

(45) Veröffentlichungstag der Patentschrift: 15.05.91

(51) Int. Cl.5: **C23C 14/08,** H01F 10/24, H01F 41/18

(21) Anmeldenummer: 85201046.1

(22) Anmeldetag: 01.07.85

(54) Verfahren zur Herstellung Wismut-substituierter ferrimagnetischer Granatschichten.

(30) Priorität: 03.07.84 DE 3424467

(43) Veröffentlichungstag der Anmeldung:
08.01.86 Patentblatt 86/02

(45) Bekanntmachung des Hinweises auf die
Patenterteilung:
15.05.91 Patentblatt 91/20

(84) Benannte Vertragsstaaten:
**DE FR GB**

(56) Entgegenhaltungen:
**WO-A-85/02292**

**JOURNAL OF APPLIED PHYSICS, Band 57,
Nr. 8, Teil 2B, 15. April 1985, Seiten
3885-3887, American Institute of Physics,
Woodbury, New York, US; J.-P. KRUMME et
al.: "Bismuth iron garnet films prepared by rf
magnetron sputtering"**

(73) Patentinhaber: **Philips Patentverwaltung
GmbH
Wendenstrasse 35 Postfach 10 51 49
W-2000 Hamburg 1(DE)DE**

Patentinhaber: **N.V. Philips' Gloeilampenfabrieken
Groenewoudseweg 1
NL-5621 BA Eindhoven(NL)FR GB**

(72) Erfinder: **Krumme, Jens-Peter, Dr. Ing.
Heydornweg 4
W-2000 Hamburg 55(DE)**
Erfinder: **Willich, Peter, Dr. Dipl.-Chem.
Hagenkamp 68
W-2083 Halstenbek(DE)**
Erfinder: **Six, Rolf
Am Trotz 9
W-2359 Henstedt-Ulzburg(DE)**

(74) Vertreter: **Nehmzow-David, Fritzi-Maria et al
Philips Patentverwaltung GmbH Wendenstrasse 35 Postfach 10 51 49
W-2000 Hamburg 1(DE)**

JOURNAL OF APPLIED PHYSICS, Band 57, Nr. 8, Teil 2B, American Institute of Physics, Woodbury, New York, US; M. GOMI et al.: "Rf sputtering of highly Bi-substituted garnet films on glass substrates for magneto-optic memory"

THIN SOLID FILMS, Band 114, Nr. 1/2, April 1984, Seiten 69-107, Elsevier Sequoia, Lausanne, CH; P. HANSEN et al.: "Magnetic and magneto-optical properties of garnet films"

PHILIPS TECHNICAL REVIEW, Band 41, Nr. 2, 1983, Seiten 33-45, Eindhoven, NL; P. HANSEN et al.: "Optical switching with bismuth-substituted iron garnets"

**EP 0 167 213 B1**

**Beschreibung**

Die Erfindung betrifft ein Verfahren zur Herstellung Wismut-substituierter ferrimagnetischer Granatschichten auf einem Substrat durch HF-Kathodenzerstäubung unter Einsatz eines Targets, das die am Schichtaufbau beteiligten Elemente in Form von Oxiden enthält.

Ein Verfahren, bei dem Wismut-substituierte Eisengranatschichten mittels HF-Kathodenzerstäubung auf einem Substrat abgeschieden werden, ist in der deutschen Patentanmeldung P 33 43 768.8 vorgeschlagen worden. Ein besonderes Problem bei der Abscheidung von Wismut-substituierten Eisengranatschichten mittels HF-Kathodenzerstäubung ist die im Vergleich zu den anderen Bestandteilen der Schicht wesentlich höhere Zerstäubungsausbeute des Wismuts in oxidischer Bindung. Bei der Durchführung des klassischen HF-Plasmazerstäubens mit den üblicherweise eingesetzten Parametern findet deshalb durch Rückzerstäubungsprozesse und thermische Prozesse, z.B. infolge des Beschusses mit energetischen Sekundärelektronen, an der Substratelektrode eine Verarmung an Wismut in den erzeugten Schichten statt. Das Problem der Wismutverarmung wird mit dem bekannten Verfahren dadurch gelöst, daß erstens ein Überschuß an Wismutoxid im Target vorgegeben ist und daß zweitens durch eine HF-Vorspannung an der Substratelektrode (sogenannter Substrat-Bias) eine Feineinstellung des Wismutgehaltes in der wachsenden Schicht ermöglicht wird.

Die Herstellung von dünnen ferrimagnetischen Granatschichten hat in den letzten Jahren zunehmend an Bedeutung gewonnen wegen ihrer Anwendungsmöglichkeiten auf magnetischem bzw. magnetooptischem Gebiet, z.B. als Displays, für optische Drucker, für Blasendomänenanordnungen, in Gyrolasern und für Bauelemente im Bereich der optischen Kommunikation, z.B. aktive Elemente in Speichervorrichtungen, die mittels elektromagnetischer Strahlung adressierbar sind.

Bei der Herstellung von Granatschichten hat die Abscheidung mittels HF-Kathodenzerstäubung (HF-Plasmazerstäubung oder RF-Diodensputtering) für die industrielle Fertigung an Interesse gewonnen, weil auf diese Weise die Schwierigkeit, homogene Abscheidungen dielektrischer Schichten auch über größere Flächen zu erreichen, noch am ehesten überwunden werden kann.

Das traditionelle Vorgehen, einkristalline Granatschichten mittels Flüssigphasenepitaxie (LPE) auf einkristallinen Substraten mit etwa angepaßter Gitterkonstante abzuscheiden, ist teuer und bislang noch nicht soweit entwickelt, daß eine Großserienfertigung mit reproduzierbarem Erfolg arbeiten kann. Schwierigkeiten ergeben sich z.B. bei den einkristallinen Substraten, die - abhängig von den Abmessungen der Einkristalle, aus denen sie geschnitten werden - nicht in beliebiger Größe hergestellt werden können.

Dem Flüssigphasenepitaxieprozeß gegenüber bietet die HF-Plasmazerstäubung für die Herstellung von Granatschichten eine Reihe von Vorteilen; es werden keine Edelmetalle für die einzusetzenden Vorrichtungen benötigt, es kann der große technologische Aufwand mit der Herstellung einkristalliner Substrate entfallen und es ist auch eine kontinuierliche Prozeßführung möglich. Darüberhinaus bietet der HF-Plasmazerstäubungsprozeß den Vorteil einer größeren Vielseitigkeit, da eine Vielfalt von Substrat/Schichtkombinationen möglich ist und Schichten größerer Abmessungen hergestellt werden können.

Nach dem in P 33 43 768.8 vorgeschlagenen Verfahren können Schichten gewünschter stöchiometrischer Zusammensetzung reproduzierbar aufgestäubt werden, deren intrinsische, optische, magnetooptische, magnetische und kristallographische Eigenschaften durchaus denen durch Flüssigphasenepitaxie hergestellter Schichten entsprechen. Es hat sich jedoch gezeigt, daß in den nach diesen Verfahren abgeschiedenen Schichten Defekte in Form von Partikeln einer Größe = $10 \mu m$ vorhanden sein können, die im Hinblick auf eine möglichst hohe Schichtperfektion nicht erwünscht sind.

Der Erfindung liegt die Aufgabe zugrunde, das eingangs genannte Verfahren derart zu verbessern, daß Wismut-substituierte ferrimagnetische Granatschichten durch HF-Kathodenzerstäubung nahezu defektfrei hergestellt werden können.

Diese Aufgabe wird erfindungsgemäß dadurch gelöst, daß ein Target eingesetzt wird, das Wismut in Form einer Oxidverbindung mit bestimmter Stöchiometrie, in der Wismut und mindestens ein am Schichtaufbau beteiligtes Element mit einer deutlich unter der Zerstäubungsrate für Wismut liegenden Zerstäubungsrate auf festen Gitterplätzen eingebaut ist, enthält.

Der Erfindung liegt die Erkenntnis zugrunde, daß die bei den bekannten Schichten festgestellten Defekte auf eingelagerte Partikel zurückzuführen sind, die aus dem Target stammen. Das bekannte Target enthält wegen des sehr hohen Überführungsverlustes an Wismut überschüssiges freies $Bi_2O_3$. Wegen der im Vergleich zu den anderen Targetbestandteilen hohen Zerstäubungsausbeute des $Bi^{3+}$ verarmt die Targetoberfläche drastisch an $Bi_2O_3$ und zerklüftet. Es verbleiben im Target hervorstehende Phasenbestandteile, die eine langsamere Zerstäubungsrate haben, z.B. $GdfeO_3$ oder $Gd_3Fe_5O_{12}$. Das hohe negative elektrische Potential der Targetoberfläche während der HF-Kathodenzerstäubung bewirkt dann eine Abstoßung der gleich geladenen, hervorstehenden Teilchen und deren Einbau in die wachsende Schicht. Es ist auch zu vermuten, daß die $Bi_2O_3$-Matrix des bekannten Targets in Oberflächennähe wegen Durchschreitung von kristallographischen Phasenübergängen desintegriert und die Verkettung mit den anderen Phasenbestandteilen lockert.

Es hat sich nun gezeigt, daß Defekte in der oben beschriebenen Art in der abgeschiedenen Schicht nahezu vermieden werden können, wenn dafür gesorgt wird, daß Wismut nicht in Form von $Bi_2O_3$ im Target vorhanden ist, sondern z.B. in Form einer Doppeloxidverbindung oder einer ternären Oxidphase. Durch die molekulare Bindung von $Bi^{3+}$ an andere Elemente mit geringerer Zerstäubungsausbeute, z.B. $Fe^{3+}$ und/oder $Gd^{3+}$, wird die effektive Zerstäubungsausbeute von $Bi^{3+}$ herabgesetzt.

Wenn die im Target vorhandene Wismutmenge nicht ein Bi-Atom/Formeleinheit überschreitet, können perfekte Schichten, d.h. Schichten ohne Einbau von Fremdpartikeln, mit einer klassischen HF-Kathodenzerstäubungsvorrichtung in Diodenanordnung erreicht werden unter der Voraussetzung, daß $Bi^{3+}$ im Target molekular an ein (oder mehrere) Kation(en) mit niedrigerer Zerstäubungsausbeute gebunden ist. Sollen höhere Wismutgehalte in den herzustellenden Schichten erreicht werden und/oder soll zum Erreichen spontaner Kristallisation in der wachsenden Schicht mit höheren Temperaturen am Substrat gearbeitet werden, was mit Hinblick auf die Korrosion der Vorrichtung nur in Sauerstoff-freiem Plasma möglich ist, muß das Plasma nach einer weiteren, der Erfindung zugrundeliegenden Erkenntnis von der wachsenden Schicht entfernt gehalten werden, um Rückzerstäubungsverluste an $Bi^{3+}$ weitgehend zu vermeiden; dies kann erreicht werden durch Einsatz einer Magnetron-Kathode.

Daher wird nach einer vorteilhaften Weiterbildung der Erfindung als Targetelektrode ein Magnetron, in das die für den Zerstäubungsprozeß erforderliche HF-Leistung eingespeist wird, eingesetzt. Hiermit ist dann der Vorteil verbunden, daß Targets eingesetzt werden können, deren Zusammensetzung relativ dicht an der stöchiometrischen Zusammensetzung der herzustellenden Schicht liegt, bei denen der Wismutgehalt also nur geringfügig höher ist, als es der stöchiometrischen Zusammensetzung der herzustellenden Schicht entspricht. Ein Magnetron bewirkt, daß das Plasma in Targetnähe konzentriert und damit der Ionenbeschuß der wachsenden Schicht drastisch vermindert wird, so daß einmal in der abgeschiedenen Schicht vorhandenes $Bi^{3+}$ nicht rückabgestäubt wird.

Mit der Anwendung eines Magnetrons ist darüberhinaus der Vorteil verbunden, daß der Abstand zwischen Target und Substrat im Vergleich zu dem bekannten Verfahren, das mit einer klassischen HF-Kathodenzerstäubungsanlage in Diodenanordnung arbeitet, weit mehr als verdoppelt werden kann, weil die mit einem Magnetron zu erreichende Zerstäubungsrate des gesamten Targetmaterials wesentlich höher ist.

Nach einer weiteren vorteilhaften Ausgestaltung der Erfindung wird daher ein Abstand zwischen der Targetelektrode und der Substratelektrode zwischen 40 und 100 mm, gewählt. Wie oben bereits näher ausgeführt wurde, ist es ein besonderes Problem bei der Abscheidung von Wismut-substituierten Eisengranatschichten mittels HF-Kathodenzerstäubung, daß das Wismut in oxidischer Bindung im Vergleich zu den anderen Bestandteilen der Schicht eine wesentlich höhere Zerstäubungsausbeute hat.

Dieser Effekt macht sich selbstverständlich nicht nur bei der Zerstäubung des Targets bemerkbar, sondern er wirkt auch, wenn die wachsende Schicht einem Ionenbeschuß aus dem Plasma ausgesetzt wird, wobei ein Rückzerstäuben (backsputtern) von in der Schicht bereits vorhandenem $Bi^{3+}$ erfolgt, also eine Verarmung der Schicht an $Bi^{3+}$ eintritt. Bei Anwendung einer Magnetron-Elektrode kann der Abstand zwischen Targetelektrode und Substratelektrode aufgrund der hohen Zerstäubungsleistung des Magnetrons so gewählt werden, daß sogenannte backsputter-Effekte kaum auftreten.

Nach einer weiteren vorteilhaften Ausgestaltung der Erfindung wird das Substrat auf eine Temperatur im Bereich zwischen 300 und 650°C, vorzugsweise auf eine Temperatur von etwa 550°C aufgeheizt. Dieser Bereich ist gerade für Glassubstrate von außerordentlicher Bedeutung. Unter 300°C entstehen unter Umständen noch keine optimalen Schichten und 650°C sind für manche Gläser unter Umständen schon wieder zuviel. Gerade bei einer Prozeßtemperatur von etwa 550°C liegt eine eventuelle zweite Phase in feinster Verteilung vor, so daß deswegen eine Abweichung von der Formelzusammensetzung des Targets von einer bestimmten Stöchiometrie unkritisch ist. Hiermit ist der Vorteil verbunden, daß z.B. durch Kondensationsphänomene bedingte Verluste von $Bi^{3+}$, infolge einer bereits einsetzenden Bildung von Kristalliten in der röntgenamorphen Schicht, verringert werden. Dies bedeutet auch, daß, wenn bei so niedrigen Temperaturen wie z.B. 550°C gearbeitet wird, spontan kristallisierte Schichten auch ohne Nachtempern erreicht werden können.

Nach einer weiteren vorteilhaften Ausgestaltung der Erfindung wird die Schicht in einer Edelgas-Atmosphäre, eines Drucks von 1,1 bis $10 \times 10^{-3}$ mbar abgeschieden. Es hat sich gezeigt, daß der Anteil an in den Schichten vorhandenem Wismut insbesondere erhöht werden kann, wenn statt in einer sauerstoffhaltigen Edelgasatmosphäre in einer reinen Edelgasatmosphäre abgeschieden wird, wobei besonders gute Ergebnisse erzielt werden, wenn Krypton gewählt wird.

Nach einer vorteilhaften Weiterbildung der Erfindung werden Schichten der allgemeinen Zusammensetzung $(Gd,Bi)_3(Fe,Ga,Al)_5O_{12}$ abgeschieden. Gute Ergebnisse wurden erreicht wenn das verwendete Target eine der nachfolgend angegebenen Einwaage-Zusammensetzungen hatte (Gew.%):

| $Gd_2O_3$ | 25,7 | | $Gd_2O_3$ | 17,2 |
|---|---|---|---|---|
| $BiFeO_3$ | 48,1 | bzw. | $Bi_{2,3}Gd_{0,7}Fe_5O_{12}$ | 71,1 |
| $Fe_2O_3$ | 17,6 | | $Fe_2O_3$ | 3,1 |
| $Al_2O_3$ | 3,4 | | $Al_2O_3$ | 3,4 |
| $Ga_2O_3$ | 5,2 | | $Ga_2O_3$ | 5,2 |

Nach dem erfindungsgemäßen Verfahren hergestellte Wismutsubstituierte Eisengranatschichten haben den Vorteil, daß ihre optischen und magnetooptischen Eigenschaften wie auch die Temperaturabhängigkeit der Sättigungsmagnetisierung mit den Werten von mittels Flüssigphasenepitaxie hergestellten Schichten entsprechender Zusammensetzung nahezu übereinstimmt, daß aber außerdem, anders als bei mittels Flüssigphasenepitaxie hergestellten Schichten, die vorliegenden Schichten über ihre gesamte Schichtdicke eine hohe Homogenität aufweisen.

Ein weiterer Vorteil des erfindungsgemäßen Verfahrens ist, daß mit einem sauerstoffreien Edelgasplasma gearbeitet werden kann, so daß wesentlich höhere Substrattemperaturen als beim bereits vorgeschlagenen Verfahren, das mit einer Sauerstoffatmosphäre arbeitet, möglich sind. Eine höhere Substrattemperatur begünstigt eine spontane Kristallisation der abgeschiedenen Schicht.

Beispiele

Als Ausführungsbeispiel der Erfindung wird die Herstellung von Wismut-substituierten Gadolinium-Eisengranat-Schichten, bei denen ein Teil des Eisens durch Aluminium und Gallium substituiert ist, beschrieben.

Für die HF-Kathodenzerstäubung können im Handel erhältliche, mit HF-Spannung zu betreibende Kathodenzerstäubungsanlagen mit einer magnetischen Targetelektrode (Magnetron) benutzt werden, wobei als Hilfsvorrichtung eine Meßvorrichtung zur Messung der effektiven HF-Spannung sowohl an der Targetelektrode als auch an der Substratelektrode vorzusehen ist. Die Magnetronelektrode ist liegend in einen herkömmlichen Vakuumrezipienten eingebaut. Die für den Zerstäubungsprozeß erforderliche HF-Leistung wird über Impedanzanpassungsglieder in die Targetelektrode eingespeist, wobei die Einstellung der HF-Spannung an der Targetelektrode durch Regelung der Kapazitäten der Impedanzanpassungsglieder erfolgt. Die Konstanthaltung der HF-Spannung an der Targetelektrode auf Werte besser als ± 1% wird über eine Rechnersteuerung erreicht. Als Energiequelle für die Zerstäubungseinrichtung dient ein normaler HF-Generator, der bei einer Ausgangsleistung von 160 W betrieben wird. Die Betriebsfrequenz liegt bei 13,56 MHz. Als Target (kathodische Zerstäubungsquelle) dienen durch Heißpressen aus den Oxiden der am Schichtaufbau beteiligten Elemente hergestellte Körper eines Durchmessers von 75 mm, einer Dicke von 4 mm und einer Porosität von 4% mit folgenden Einwaage-Zusammensetzungen (Angaben in Gew.%):

| | | | |
|---|---|---|---|
| $Gd_2O_3$ | 25,7 | $Gd_2O_3$ | 17,2 |
| $BiFeO_3$ | 48,1 | $Bi_{2,3}Gd_{0,7}Fe_5O_{12}$ | 71,1 |
| | bzw. | | |
| $Fe_2O_3$ | 17,6 | $Fe_2O_3$ | 3,1 |
| $Al_2O_3$ | 3,4 | $Al_2O_3$ | 3,4 |
| $Ga_2O_3$ | 5,2 | $Ga_2O_3$ | 5,2 |

Der keramische Prozeß zur Herstellung des Targets aus den genannten Oxiden wird so geführt, daß kein freies $Bi_2O_3$ rückgebildet wird.

Der Targetkörper wird an einer Trägerplatte mit einem gut wärmeleitfähigen Kleber (mit Silberpulver gefülltes Epoxidharz) befestigt und dieser Verbundkörper wird dann auf der Targetelektrode befestigt.

Der Targetkörper kann auch durch Kaltpressen der Oxide der am Schichtaufbau beteiligten Elemente und anschließendes Sintern hergestellt werden.

Um Verlustwärme abzuführen, ist es zweckmäßig, z.B. durch Wasser gekühlte Targetelektroden zu verwenden.

Als Substratelektrode wurde eine, auf eine Temperatur von 355 bis 550° C aufgeheizte hochfrequenztaugliche Elektrode eines Durchmessers von 150 mm eingesetzt. Als Substrate wurden Ca/Mg/Zr-substituierte Gadolinium-Gallium-Granat-Einkristallscheiben mit (111)-Orientierung oder Platten aus Gläsern mit hoher Transformationstemperatur und einem, dem aufzubringenden Schichtmaterial angepassten thermischen Ausdehnungskoeffizienten verwendet. Die Auswahl des Substrates hängt ab vom Anwendungszweck der hergestellten Schicht. Werden großflächige Schichten, z.B. für Displays, benötigt, sind insbesondere Glassubstrate geeignet.

Die Zerstäubungsapparatur wird zunächst mit einer Vakuumpumpe bis zu einem Druck von etwa $10^{-5}$ mbar evakuiert, anschließend wird ein Edelgas, vorzugsweise Krypton eines Drucks von $5\times10^{-3}$ mbar eingeleitet. Der Elektrodenabstand beträgt 50 - 80 mm. Die Niederschlagsrate liegt bei etwa 0,5 bis $2\mu m/h$ bei Anwendung eines heißgepreßten Targetkörpers.

Die an der HF-Zuleitung an der Rückseite der Targetelektrode gemessene HF-Spannung beträgt = $200V_{eff}$, die Substratspannung ist schwebend.

Vor der Abscheidung der Schichten (typische Schichtdicken liegen bei 1 bis 2 $\mu m$) werden Target und Substrat jeweils durch Zerstäuben im Plasma angeätzt, um eine Gleichgewichtsverteilung der Phasenbestandteile an der Oberfläche einzustellen. Die Vorätzzeit reduziert sich bei weiteren Experimenten an ein und demselben Target auf etwa 0,5 bis 1 h, bis sich am Target das Gleichgewichtspotential stabilisiert hat.

Nach Abscheidung in der Kathodenzerstäubungsanlage sind die Schichten weitgehend röntgenamorph. Eine Umwandlung in kristalline Wismut-substituierte Eisengranatschichten erfolgt durch Erhitzen in Sauerstoffatmosphäre bei einer Temperatur von etwa 730° C für den Fall, daß einkristalline Granatsubstrate verwendet werden und bei einer Temperatur von etwa 780° C für den Fall, daß Glassubstrate verwendet werden.

Die besonderen Vorteile des vorliegenden Verfahrens liegen darin, daß trotz der im Vergleich zu den anderen Bestandteilen des Targets wesentlich höheren Zerstäubungsausbeute des $Bi^{3+}$ in der abgeschiedenen Schicht hohe Wismutgehalte reproduzierbar erreicht werden können, wobei die abgeschiedenen Schichten eine hohe Homogenität über die gesamte Schichtdicke aufweisen und nahezu frei von Defekten in Form von größeren Partikeln sind, die aus dem Target infolge Zerklüftung aufgrund der sehr unterschiedlichen Zerstäubungsraten von $Bi^{3+}$ und der übrigen aus dem Target abzustäubenden Ionen, wie $Fe^{3+}$, $Gd^{3+}$, $Ga^{3+}$, $Al^{3+}$, herausgerissen werden.

Wie gut das Überführungsverhalten der beteiligten Elemente aus den Targets in die wachsende Schicht ist, zeigt die nachfolgende Tabelle (die in der Tabelle angegebenen Schichtzusammensetzungen sind nicht stöchiometrisch).

| Probe | Schichtzusammensetzung | | | | | | | | [Gew.%] | Gas-atmosphäre | Gasdruck [mbar] | Elektro-den-abstand [mm] | Sub-strat-tempera-tur [°C] |
|---|---|---|---|---|---|---|---|---|---|---|---|---|---|
| | Gd | Bi | Fe | Ga | Al | Ar | Kr | 0 | $\Sigma$ | | | | |
| M 304 | 21,6 | 30,2 | 21,8 | 3,9 | 2,1 | 0,6 | – | 19,2 | 99,4 | Argon | $5 \times 10^{-3}$ | 50 | 362 |
| M 309 | 21,0 | 32,0 | 20,4 | 3,9 | 2,2 | 0,5 | – | 19,0 | 99,0 | " | " | 80 | 360 |
| M 310 | 20,9 | 34,8 | 19,6 | 3,7 | 2,0 | 0,3 | – | 18,7 | 100,0 | " | " | " | 550 |
| M 313 | 21,2 | 25,2 | 20,3 | 4,0 | 2,2 | 0,4 | – | 18,2 | 91,5 | 1 $O_2$+4 Ar | " | " | 355 |
| M 314 | 14,5 | 37,1 | 21,5 | 4,3 | 2,7 | – | 0,2 | 19,6 | 99,9 | Krypton | " | " | 358 |

EP 0 167 213 B1

Aus Versuchen hat sich ergeben, daß eine Veränderung des Argon-Druckes $(3{,}5 \rightarrow 5 \rightarrow 7 \times 10^{-3}$ mbar) kaum einen Einfluß hat auf die Menge des abgeschiedenen Wismuts in der Schicht. Als vorteilhaft in bezug auf die Menge an abgeschiedenem Wismut in der Schicht erweist sich eine reine Krypton-Atmosphäre, wogegen ein Sauerstoffanteil in der Edelgasatmosphäre die Überführung von Wismut aus dem Target in die Schicht nachteilig beeinflußt.

**Ansprüche**

1. Verfahren zur Herstellung Wismut-substituierter ferrimagnetischer Granatschichten auf einem Substrat durch HF-Kathodenzerstäubung unter Einsatz eines Targets, das die am Schichtaufbau beteiligten Elemente in Form von Oxiden enthält, dadurch gekennzeichnet, daß ein Target eingesetzt wird, das Wismut in Form einer Oxidverbindung mit bestimmter Stöchiometrie, in der Wismut und mindestens ein am Schichtaufbau beteiligtes Element mit einer deutlich unter der Zerstäubungsrate für Wismut liegenden Zerstäubungsrate auf festen Gitterplätzen eingebaut ist, enthält.

2. Verfahren nach Anspruch 1, dadurch gekennzeichnet, daß als Targetelektrode ein Magnetron, in das die für den Zerstäubungsprozeß erforderliche HF-Leistung eingespeist wird, eingesetzt wird.

3. Verfahren nach Anspruch 1, dadurch gekennzeichnet, daß Wismut in einer Doppeloxidverbindung in die Oxidmischung zur Herstellung des Targets eingeführt wird.

4. Verfahren nach Anspruch 3, dadurch gekennzeichnet, daß Wismut in Form von $BiFeO_3$-Pulver in die Oxidmischung zur Herstellung des Targets eingeführt wird.

5. Verfahren nach Anspruch 1, dadurch gekennzeichnet, daß Wismut in einer ternären Oxidphase in die Oxidmischung zur Herstellung des Targets eingeführt wird.

6. Verfahren nach Anspruch 5, dadurch gekennzeichnet, daß Wismut in Form von $(Gd, Bi)_3 Fe_5 O_{12}$-Pulver in die Oxidmischung zur Herstellung des Targets eingeführt wird.

7. Verfahren nach Anspruch 1, dadurch gekennzeichnet, daß Schichten der allgemeinen Formel $(Gd, Bi)_3 (Fe,Ga,Al)_5 O_{12}$ abgeschieden werden.

8. Verfahren nach Anspruch 1, dadurch gekennzeichnet, daß das auf der Substratelektrode angeordnete Substrat auf eine Temperatur im Bereich von $300\,^{\circ}C$ bis $650\,^{\circ}C$ aufgeheizt wird.

9. Verfahren nach Anspruch 8, dadurch gekennzeichnet, daß das Substrat auf eine Temperatur von etwa $550\,^{\circ}C$ aufgeheizt wird.

10. Verfahren nach mindestens einem der vorhergehenden Ansprüche, dadurch gekennzeichnet, daß das Target die nachfolgend angegebene Einwaage-Zusammensetzung hat (Gew.%):

EP 0 167 213 B1

| | |
|---|---|
| $Gd_2O_3$ | 25,7 |
| $BiFeO_3$ | 48,1 |
| $Fe_2O_3$ | 17,6 |
| $Al_2O_3$ | 3,4 |
| $Ga_2O_3$ | 5,2 |

11. Verfahren nach mindestens einem der vorhergehenden Ansprüche, dadurch gekennzeichnet, daß das Target die nachfolgend angegebene Einwaage-Zusammensetzung hat (Gew.%):

| | |
|---|---|
| $Gd_2O_3$ | 17,2 |
| $Bi_{2,3}Gd_{0,7}Fe_5O_{12}$ | 71,1 |
| $Fe_2O_3$ | 3,1 |
| $Al_2O_3$ | 3,4 |
| $Ga_2O_3$ | 5,2 |

12. Verfahren nach Anspruch 2, dadurch gekennzeichnet, daß die Schicht in einer Edelgasatmosphäre eines Drucks im Bereich von 1,0 bis $10 \times 10^{-3}$ mbar abgeschieden wird.

13. Verfahren nach Anspruch 12, dadurch gekennzeichnet, daß die Schicht in einer Argonatmosphäre abgeschieden wird.

14. Verfahren nach Anspruch 2, dadurch gekennzeichnet, daß ein Abstand zwischen Targetelektrode und Substratelektrode zwischen 40 und 100 mm gewählt wird.

15. Verwendung von nach dem Verfahren gemäß den Ansprüchen 1 bis 14 hergestellten ferrimagnetischen Granatschichten in optischen Speichern.

16. Verwendung von nach dem Verfahren gemäß den Ansprüchen 1 bis 14 hergestellten ferrimagnetischen Granatschichten in optischen Druckern.

17. Verwendung von nach dem Verfahren gemäß den Ansprüchen 1 bis 14 hergestellten ferrimagnetischen Granatschichten in Displays.

18. Verwendung von nach dem Verfahren gemäß den Ansprüchen 1 bis 14 hergestellten ferrimagnetischen Granatschichten als gyrotrope Wellenleiter.

**Claims**

1. A method of manufacturing bismuth-substituted ferrimagnetic garnet films on a substrate by HF cathode sputtering, using a target containing, in the form of oxides, the elements involved in the build-up of the film, characterized in that a target is used which includes bismuth in the form of an oxide compound with a certain stoichiometry, bismuth and at least one element involved in the film build-up, which element has a sputtering rate which is distinctly lower than the sputtering rate of bismuth, being incorporated in the oxide compound at fixed lattice sites.

2. A method as claimed in Claim 1, characterized

9

in that the target electrode used is a magnetron into which the HF power required for the sputtering process is fed.

3.  A method as claimed in Claim 1, characterized
    in that bismuth in a binary oxide compound is introduced into the oxide mixture for the production of the target.

4.  A method as claimed in Claim 3, characterized
    in that bismuth in the form of $BiFeO_3$ powder is introduced into the oxide mixture for the production of the target.

5.  A method as claimed in Claim 1, characterized
    in that bismuth in a ternary oxide phase is introduced into the oxide mixture for the production of the target.

6.  A method as claimed in Claim 5, characterized
    in that bismuth in the form of $(Gd, Bi)_3Fe_5O_{12}$ powder is introduced into the oxide mixture for the production of the target.

7.  A method as claimed in Claim 1, characterized
    in that films of the general formula
    $(Gd, Bi)_3(Fe, Ga, Al)_5O_{12}$ are deposited.

8.  A method as claimed in Claim 1, characterized
    in that the substrate arranged on the substrate electrode is heated to a temperature in the range from 300° C to 650° C.

9.  A method as claimed in Claim 8, characterized
    in that the substrate is heated to a temperature of approx. 550° C.

10. A method as claimed in at least one of the preceding Claims, characterized in that the target is of the following composition (% by weight):

| | |
|---|---|
| $Gd_2O_3$ | 25.7 |
| $BiFeO_3$ | 48.1 |
| $Fe_2O_3$ | 17.6 |
| $Al_2O_3$ | 3.4 |
| $Ga_2O_3$ | 5.2 |

11. A method as claimed in at least one of the preceding Claims, characterized in the target is of the following composition (% by weight):

| | |
|---|---|
| $Gd_2O_3$ | 17.2 |
| $Bi_{2.3}Gd_{0.7}Fe_5O_{12}$ | 71.1 |
| $Fe_2O_3$ | 3.1 |
| $Al_2O_3$ | 3.4 |
| $Ga_2O_3$ | 5.2 |

12. A method as claimed in Claim 2,
    characterized in that the film is deposited in an inert-gas atmosphere with a pressure in the range from 1.0 to 10 x 10$^{-3}$ mbar.

**13.** A method as claimed in Claim 12,
characterized in that the film is deposited in an argon atmosphere.

**14.** A method as claimed in Claim 2,
characterized in that the distance between the target electrode and the substrate electrode is selected to be between 40 and 100 mm.

**15.** The use in optical stores of ferrimagnetic garnet films produced according to the method claimed in Claims 1 to 14.

**16.** The use in optical printers of ferrimagnetic garnet films produced according to the method claimed in Claims 1 to 14.

**17.** The use in displays of ferrimagnetic garnet films produced according to the method claimed in Claims 1 to 14.

**18.** The use as gyrotropic waveguides of ferrimagnetic garnet films produced according to the method claimed in Claims 1 to 14.


**Revendications**

**1.** Procédé pour la fabrication de couches de grenat ferrimagnétique substitué par du bismuth sur un substrat par pulvérisation cathodique à haute fréquence à l'aide d'une cible contenant les éléments sous forme d'oxydes participant à la composition de la couche, caractérisé par l'utilisation d'une cible contenant du bismuth sous forme d'un composé d'oxyde présentant une stoechiométrie déterminée dans lequel est incorporé du bismuth et au moins un élément participant à la composition de la couche et présentant une vitesse de pulvérisation située nettement au-dessous de la vitesse de pulvérisation pour le bismuth à des sites de réseau fixes.

**2.** Procédé selon la revendication 1, caractérisé en
ce que comme électrode de cible est utilisée un magnétron auquel est amenée la puissance à haute fréquence nécessaire pour le processus de pulvérisation.

**3.** Procédé selon la revendication 1, caractérisé en
ce que le bismuth est introduit sous forme d'un composé de dioxyde dans le mélange d'oxyde pour la fabrication de la cible.

**4.** Procédé selon la revendication 3, caractérisé en
ce que le bismuth est introduit sous forme de poudre de $BiFeO_3$ dans le mélange d'oxyde pour la fabrication de la cible.

**5.** Procédé selon la revendication 1, caractérisé en
ce que le bismuth est introduit dans une phase d'oxyde ternaire dans le mélange d'oxyde pour la fabrication de la cible.

**6.** Procédé selon la revendication 5, caractérisé en
ce que le bismuth est introduit sous forme d'une poudre de $(Gd, Bi)_3Fe_5O_{12}$ dans le mélange d'oxyde pour la fabrication de la cible.

**7.** Procédé selon la revendication 1, caractérisé par
le dépôt de couches répondant à la formule générale $(Gd, Bi)_3 (Fe,Ga,Al)_5O_{12}$.

**8.** Procédé selon la revendication 1, caractérisé en
ce que le substrat déposé sur l'électrode de substrat est chauffé à une température située dans la gamme comprise entre 300° C et 650° C.

11

9. Procédé selon la revendication 8, caractérisé en
ce que le substrat est chauffé à une température d'environ 550° C.

10. Procédé selon au moins l'une des revendications précédentes, caractérisé en ce que la cible présente la composition en poids mentionnée ci-dessus (% en poids):

$$Gd_2O_3 \qquad 25,7$$
$$BiFeO_3 \qquad 48,1$$
$$Fe_2O_3 \qquad 17,6$$
$$Al_2O_3 \qquad 3,4$$
$$Ga_2O_3 \qquad 5,2$$

11. Procédé selon au moins l'une des revendications précédentes, caractérisé en ce que la cible présente la composition en poids mentionnée ci-après (% en poids):

$$Gd_2O_3 \qquad 17,2$$
$$Bi_{2,3}Gd_{0,7}Fe_5O_{12} \qquad 71,1$$
$$Fe_2O_3 \qquad 3,1$$
$$Al_2O_3 \qquad 3,4$$
$$Ga_2O_3 \qquad 5,2$$

12. Procédé selon la revendication 2, caractérisé en ce que la couche est déposée dans une atmosphère de gaz rare d'une pression située dans la gamme comprise entre 1,0 à $10 \times 10^{-3}$ mbar.

13. Procédé selon la revendication 12, caractérisé en ce que la couche est déposée dans une atmosphère d'argon.

14. Procédé selon la revendication 2, caractérisé en ce qu'une distance comprise entre 40 et 100 mm est choisie entre l'électrode de cible et l'électrode de substrat.

15. Application de couches de grenat ferrimagnétique réalisées conformément au procédé selon les revendications 1 à 14 dans des accumulateurs optiques.

16. Application de couches de grenat ferrimagnétique fabriquées conformément au procédé selon les revendications 1 à 14 dans des imprimantes optiques.

17. Application de couches de grenat ferrimagnétique fabriquées conformément au procédé selon les revendications 1 à 14 dans des dispositifs de reproduction.

18. Application de couches de grenat ferrimagnétique fabriquées conformément au procédé selon les revendications 1 à 14 comme guide d'ondes gyrotrope.